# EUROPEAN PATENT SPECIFICATION

(11) **EP 3 692 610 B1**
(45) Date of publication and mention of the grant of the patent: **02.12.2026**
(21) Application number: 18864446.2
(22) Date of filing: 03.10.2018
(51) Int. Cl.: H01S 5/042, H01S 5/062, H04B 10/50

(54) **EFFICIENCY IMPROVED DRIVER FOR LASER DIODE IN OPTICAL COMMUNICATION**
EFFIZIENZOPTIMIERTER TREIBER FÜR LASERDIODE IN DER OPTISCHEN KOMMUNIKATION
CIRCUIT D'ATTAQUE À EFFICACITÉ AMÉLIORÉE POUR DIODE LASER EN COMMUNICATION OPTIQUE

(30) Priority: 04.10.2017 US 201762568248 P
(43) Date of publication of application: 12.08.2020
(73) Proprietor: MACOM Technology Solutions Holdings, Inc., Lowell, Massachusetts 01851 (US); Bazzani, Cristiano, Irvine, CA 92606 (US); Mo, Chi, Lowell, MA 01851 (US)
(72) Inventor: BAZZANI, Cristiano, Irvine, CA 92606 (US); MO, Chi, Lowell, MA 01851 (US)
(74) Representative: Witte, Weller & Partner Patentanwälte mbB
(86) International application number: PCT/US2018/054257
(87) International publication number: WO 2019/070916

(56) References cited:
- US-A1- 2009 238 226
- US-A1- 2013 070 796
- US-A1- 2015 263 625
- US-A1- 2016 134 081
- US-B1- 8 571 079
- US-B2- 7 106 769
- US-B2- 7 778 294
- US-B2- 7 778 294
- LOHAUS LUKAS ET AL: "A Dimmable LED Driver With Resistive DAC Feedback Control for Adaptive Voltage Regulation", IEEE TRANSACTIONS ON INDUSTRY APPLICATIONS, IEEE SERVICE CENTER, PISCATAWAY, NJ, US, vol. 51, no. 4, 1 July 2015 (2015-07-01), pages 3254 - 3262, XP011663155, ISSN: 0093-9994, [retrieved on 20150715], DOI: 10.1109/TIA.2014.2387486

## Description

### Field of the Invention.

The present invention relates to laser diodes and to methods of driving laser diodes.

### Background of the Invention.

Laser diodes have found increasing usage as optical transmitters in fiber optic communications systems. In such systems, the laser diode is typically driven by a constant current from an on-chip laser driver. In some optical transmission systems, an external DC to DC converter may be used to provide a fixed supply voltage for the laser diode from a main input voltage. However, this solution is not ideal. For example, a fixed DC converter output does not compensate for the burn-in characteristics or temperature drift of the laser diode over time. Additionally, if the laser diode is operating at high frequencies, the modulation current in the laser driver can change at high speeds and the DC converter will not be able to adjust the supply voltage to provide sufficient headroom voltage for the laser diode as more or less modulation current flows into the laser and the voltage drop across it changes accordingly.

The power dissipated on or in the laser driver may be calculated as the constant current multiplied by the headroom across it. Unfortunately, the headroom voltage is not optimized in a typical system, which wastes power. It would improve the whole system efficiency if an optimized and continuously updated headroom voltage for the laser diode could be determined and applied. Besides the advantage of efficiency, an optimized and continuously updated headroom voltage would also automatically compensate for the I-V curve drift over the lifetime of the laser diode and changes due to temperature variations to keep the bias current constant.

US 7,778,294 B2, according to its abstract, relates to an optical disk apparatus in which, by obtaining the temperature in the vicinity of a laser in the apparatus, the power source voltage of the laser driver is controlled such that power consumed by the headroom of the laser driver is reduced to the maximum extent without deteriorating the current drive characteristic of the headroom when the temperature becomes higher. The laser driving current of the laser driver is monitored to control the power source of the laser driver such that the power consumed by the headroom is possibly reduced while maintaining the current drive characteristic of the headroom for the monitored current.

In particular, the written opinion of the extended European search report stated that the US 7,778,294 B2 "discloses a circuit (fig. 10 ;col. 7, line 36 - col. 7, line 26) that provides a voltage with an optimized headroom voltage to LD 103 driven by laser driver (variable current source 1002 in fig. 10) having: a headroom control circuit ("power setting" 202 + "pulse generator" 201; fig. 11 shows the resulting "headroom voltage" across transistor 1104) with an input (coupled to interface I/F 203) connected to receive the headroom voltage from a connection between LD and laser driver (fig. 10: "peak current and V-detector" 1001 sends the information to interface I/F 203 via microcomputer 118); the headroom control circuit (power setting 202 + pulse generator 201) generating a controlled voltage (from source 1002) based on the headroom voltage (input to I/F 203) and a modulation current (from modulator 116, fig. 10) of the laser driver 1002; and DC-DC converter (123/1002, fig. 10) receiving the controlled voltage from the headroom control circuit (at source 1002) and generating voltage VSO based on the controlled voltage, and applying voltage VSO as an input to the LD (fig. 11), wherein the headroom control circuit and the DC-DC converter are connected in a feedback loop with the LD to continuously provide the voltage VSO to the LD (feedback loop via "peak current and V-detector" 1001)."

US 2009/0238226 A1, according to its abstract, relates to a driver circuit for a semiconductor laser diode , in which the driver circuit drives the laser diode in the differential mode and lowers the power consumption thereof. The driver circuit includes a differential unit to provide the modulation current to the laser diode, a voltage converter to provide a positive power supply to the differential unit, a detector to detect the common mode voltage of the differential outputs of the unit, and a comparing unit to control the voltage converter dynamically such that the output common mode voltage is set in a preset reference level.

US 2013/0070796 A1, according to its abstract, relates to a DC-DC converter having an input configured to receive an input signal and an output configured to present an output signal at a different voltage than the input signal. The converter also includes at least one inductor and at least one capacitor. Two or more transistors fingers are provided such that at least one of the two or more transistor fingers comprises two or more switching transistors, each of which has an input, an output, a control input. An activation controller connect to at least one of the two or more switching transistors, the activation controller to configured to control whether the at least one of the two or more switching transistors is active or non-active. Also disclosed is a buck-boost converter with numerous controlled switches that establish the converter in either buck-boost mode, buck mode or boost mode.

### SUMMARY

Aspects of embodiments of the invention include a circuit and method that provide a headroom voltage for a laser diode driver driving the laser diode providing signals to an optical communications device. The circuit is defined in claim 1. Preferred embodiments are defined in the appended claims.

In further aspects of embodiments of the invention, the DC-DC converter may compare the control voltage to a saw-tooth waveform to generate the driver signals to modify the voltage Vout based on a value of the input. Other DC-DC converter implementations and/or control scheme can be implemented. In one embodiment, the DC-DC converter includes a plurality of switches that are controlled by the driver signals to modify the voltage Vout as needed.

According to the invention, the headroom control circuit includes at least one programmable current source and/or at least one programmable resistor. In further aspects of embodiments of the invention, a value that the at least one programmable current source and/or the at least one programmable resistor are set to control the headroom voltage of the laser driver. In one variation, a change of the value that the at least one programmable current source and/or the at least one programmable resistor are set to control the headroom voltage of the laser driver and control the voltage Vout supply to the laser diode.

According to the invention, a circuit provides a headroom voltage for a laser driver driving a laser diode, the laser diode configured to provide signals to an optical communications device. The circuit comprises a feedback loop circuit connected between the output of the laser diode and an input of the laser driver such that the feedback loop is configured to generate an output voltage Vout based on the headroom voltage and to apply the output voltage Vout to the input of the laser diode. The feedback loop circuit is configured to generate an output voltage Vout to compensate for burn-in characteristics and/or temperature drift of the laser diode over time to maintain an optimized headroom voltage for the laser driver.

The circuit according to the invention is such that the feedback loop circuit comprises a headroom control circuit having an input connected to receive the headroom voltage from the output of the laser driver. The headroom control circuit is configured to generate a controlled voltage based on the headroom voltage. And, a DC-DC converter configured to convert the controlled voltage to the voltage Vout such that the voltage Vout is applied to the input of the laser diode. In one embodiment, the DC-DC converter is configured to generate a control voltage based on the controlled voltage from the headroom control circuit and to generate driver signals to modify the voltage Vout based on a value of the control voltage. The DC-DC converter may compare the control voltage to a saw-tooth waveform to generate the driver signals to modify the voltage Vout based on a value of the control voltage.

In one embodiment, the DC-DC converter includes a plurality of switches that are controlled by the driver signals to modify the voltage Vout as needed. The headroom control circuit may include at least one programmable current source and/or at least one programmable resistor. In one variation, a value that the at least one programmable current source and/or the at least one programmable resistor are set to control the headroom voltage of the laser driver. A change of the value that the at least one programmable current source and/or the at least one programmable resistor are set to may control the headroom voltage of the laser driver and controls the voltage Vout input to the laser diode.

The invention also comprises a method of controlling a headroom voltage of a laser driver with the laser diode being driven by the laser driver and a headroom control circuit connected to receive the headroom voltage of the laser driver while a DC-DC converter connects to receive an output out the headroom control circuit and to output an output voltage Vout to an input of the laser diode. This method comprises generating a controlled voltage based on the headroom voltage with the headroom control circuit and generating a voltage Vout based on the controlled voltage with the DC-DC converter, and then applying the voltage Vout as an input to the laser diode, such that the DC-DC converter modifies the voltage Vout to compensate for burn-in characteristics or temperature drift of the laser diode over time to maintain an optimized headroom voltage for the laser driver.

The method may further comprise comparing the control voltage to a saw-tooth waveform to generate the driver signals to modify the voltage Vout. In one configuration the method further comprises controlling a plurality of switches in the DC-DC converter to modify the voltage Vout. This method may also set a value of at least one programmable current source and/or at least one programmable resistor in the headroom control circuit to set the headroom voltage to a desired value.

### BRIEF DESCRIPTION OF THE DRAWINGS

The components in the figures are not necessarily to scale, emphasis instead being placed upon illustrating the principles of the invention. In the figures, like reference numerals designate corresponding parts throughout the different views.
Figure 1 illustrates a block diagram of a circuit for providing a voltage for a laser diode, the laser diode providing signals to fiber optics, in accordance with embodiments of the present invention.
Figure 2 illustrates a DC-to-DC converter for providing a voltage to the laser diode in accordance with embodiments of the present invention.
Figure 3 illustrates a schematic diagram of a laser diode driver and associated circuitry for providing high speed current signals with optimized headroom to drive a laser diode in accordance with embodiments of the present invention.
Figure 4 illustrates a schematic diagram of the headroom control circuit (REGREF) and associated circuitry of Fig. 3, with the associated circuitry shown in detail, in accordance with embodiments of the present invention.
Figure 5 illustrates a flowchart in accordance with embodiments of the present invention.
Figure 6 illustrates test results of different Vout, Vheadroom and Delta Vheadroom values obtained when varying the programmable current source I2.
Figure 7 illustrates test results of different Vout, Vheadroom and Delta Vheadroom values obtained when varying the programmable current source I1.

### DETAILED DESCRIPTION OF PREFERRED EMBODIMENTS

In the following description, numerous specific details are set forth in order to provide a more thorough description of embodiments of the present invention. It will be apparent, however, to one skilled in the art, that the embodiments of the present invention may be practiced without these specific details. In other instances, well-known features have not been described in detail so as not to obscure the embodiments of the present invention.

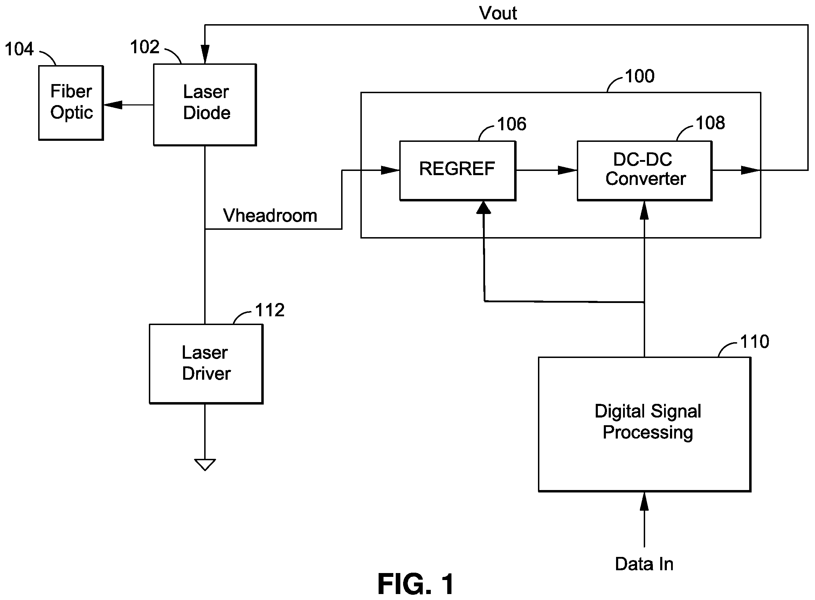

Figure 1 illustrates a block diagram of a circuit 100 for providing an optimized headroom to a laser diode 102. The laser diode 102 of Fig. 1 may be used to provide signals in optical communications, such as providing signals to optical fiber 104, for example of for free space communications. However, other uses of the laser diode 102 may also be utilized with preferred embodiments of the invention.

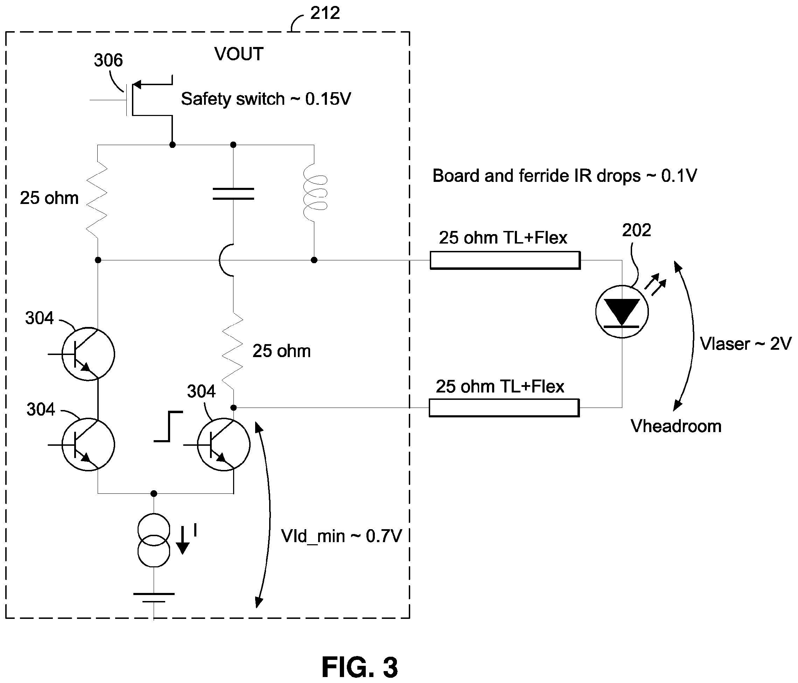

Headroom is defined herein as the difference between the supply voltage and the sum of the individual voltage drops along a single circuit path. The headroom for a laser driver as shown in Fig. 1 would be the voltage applied to the laser diode (Vout) minus the drop across the laser diode and any circuitry associated with the driver disposed between the laser diode 102 and Vout. A laser driver such as npn transistors 304 and 305 shown in Fig. 3 typically may need about 0.7V of headroom.

If the voltage at the laser diode input (Vout) were 3.3 volts (as defined for VccT by the SFP+ High Speed Electrical Interface Standard SFF-8431), then the headroom for the laser driver may be insufficient due to the above-described voltage drop increase. Accordingly, embodiments of the present invention continuously adjust the voltage Vout to provide an optimized headroom for the laser driver.

Additionally, the laser driver 212 is operated at high frequency in turning on and off the laser diode 102 by sending pulses of current into the laser diode 102, 202, typically using a square wave signal having a very sharp edge. In turning on and off the laser, the current in the circuit is sent through the laser diode 202 (when the laser diode is turned on) or through the branch of the circuit of Fig. 3 including the bipolar transistors 304 (when the laser diode is turned off).

However, because of the high frequency effects, when the square pulse is applied, in the beginning only the characteristic impedance of the load is applied (for example 25 Ohms in the case of DML lasers) because the signal has not yet traveled along the transmission line, but when the signal travels along the transmission line and is reflected back, an additional peak of voltage is present which is typically equal to the modulation current I mod times the resistance equivalent of the laser Reql. The Reql of a laser is a quantity that depends on the physical dimensions and manufacturing characteristics of the laser and optical subassembly construction (bond wires leading to the laser, flex-cables connecting the laser driver board to the laser, etc.). This peak voltage is typically about 1V. After the edge of the square wave has passed, now a continuous mode type of condition of is present and current is flowing into the laser diode, and the drop across the laser diode 202 is equal to the diode voltage of the laser plus the dc resistance of the laser times the current. The dc resistance of the laser diode is smaller than the Reql of the laser diode (the high frequency resistance of the laser diode). To make the driver not be compressed during the transition between turning off and on of the laser diode, a higher voltage needs to be applied than during purely DC operation due to the additional peak voltage.

As shown in Fig. 3 illustrating the laser driver 212 in further detail, in typical DML applications, Vout must be about 4V or greater to provide sufficient headroom to the n-p-n transistors 304, 305 of the laser driver considering the associated voltage drops across the laser diode 202 and the circuitry associated with the laser driver 212 when considering the high frequency effects. For an extreme example, the safety switch 306 may have a voltage drop of ~ 0.15V, the board and ferride voltage drops may be ~0.1V, the voltage drop across the laser diode 202 may be ~2.0V and as explained above, the peak voltage may be about 1.0V reflected back from the transmission line. Thus, to provide the needed headroom voltage of ~0.7V, Vout should be ~ 0.15V + 0.1V +2.0V +0.7V +1.0V, or around 4.0V. This would prove problematic using a module with a 3.3V supply. Accordingly, embodiments of the present invention can provide a Vout of approximately 4.0V or greater for worst case conditions.

The circuit 100 of Fig. 1 for providing an optimized headroom to the laser diode 102 includes a REGREF 106 and a DC-DC converter 108. The REGREF 106 is a headroom control circuit that provides a controlled voltage to the DC-DC converter 108. The DC-DC converter 108 is configured to convert the voltage provided by the REGREF 106 to a voltage Vout, which is used as an input to the laser diode 102. The digital signal processing 110 will monitor the performance of the laser diode and processes to send appropriate signals to the DC-DC converter 108, for modulation of the output voltage Vout, so that data can be provided to the fiber optic 104 with a low error rate.

The REGREF 106 receives as digital command from digital signal processing 110 and an input a voltage Vheadroom from the output of the laser driver 112, which may be used in a feedback loop to adjust the voltage Vout applied as an input to laser diode 102. The headroom voltage of the laser driver may be adjusted by the REGREF 106 to provide a desired headroom voltage and to automatically compensate for changes in the modulation current.

The laser driver 112, 212 modulates the current in the laser diode 102 to transmit the optical signal at 28 Gbps, although other speeds could be used. The average current required by the laser diode 102, 202 changes as a function of temperature as well as aging effects. The voltage drop across the laser diode 102 will change accordingly. The DC-DC converter 108 account for or react to the very high frequency reflections created by the mismatch impedance of the laser driver 112 with respect to the laser diode 102. This reflection depends on the impedances at play in the system (in particular laser bonding inductances) and is fairly constant for a given system. This is referred to herein as equivalent laser resistance or Reql. These reflections are also proportional to the modulation current (Imod).

The laser driver 112 may be a DML (direct modulated laser) driver. To guarantee the DML driver performance, the headroom should be: $Vheadroom = V 1 d_min + Imod * Req 1$ (1) where Vld_min is the minimum dc voltage at the output of the laser driver to guarantee performance (this is usually determined by the design and is in the order of 0.7V), Reql is the equivalent impedance of the laser diode 102, 202 which is proportional to the reflection from the transmission line, and Imod is the modulation current in the laser diode 102. As explained above Reql*Imod is typically about 1.0V.

The power dissipation in the laser driver 112 can be calculated as in equation (2) below. Equation (2) shows that the power dissipation (Pdiss) equals the headroom voltage (Vheadroom) times the average modulation current (Iave). If the headroom voltage is too low, the laser driver performance will suffer and error rate will increase. If the headroom voltage is too high, not only will the power dissipation be suboptimal, but also there is a risk of breakdown for the high frequency bipolar transistors 304 used in the laser driver 112. $Pdiss = Vheadroom * Iave$ (2)

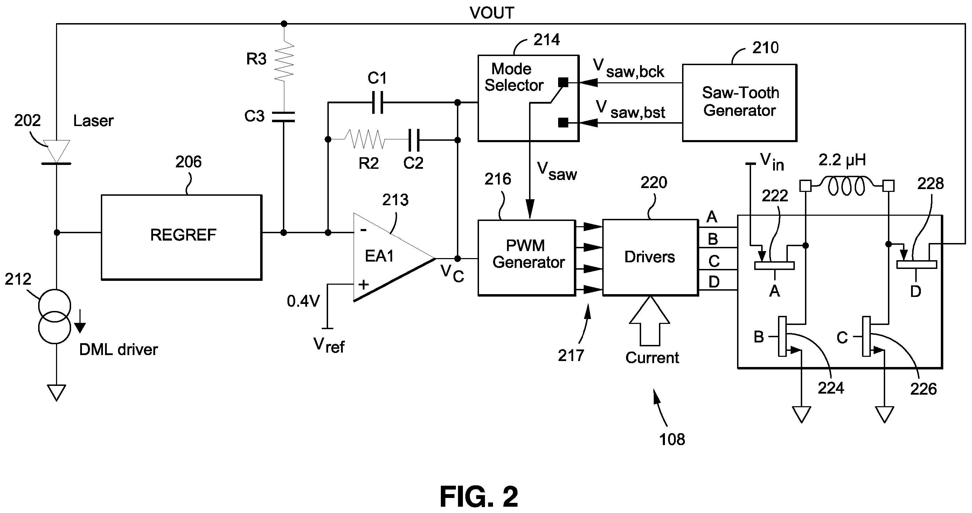

Further details of the DC-DC converter 108 and its connection to the REGREF 206, laser diode 202 and laser driver 212 are illustrated in Fig. 2. The DC-DC converter 108 outputs voltage Vout to the laser diode 202, which is driven by the laser driver 212. The REGREF 206 adjusts the voltage received at its input to output a voltage to error amplifier EA1 213, with a voltage of 0.4V applied at the positive input of EA1 213 to produce control voltage Vc.

The saw-tooth generator 218 generates saw tooth waveforms Vsaw.bck and Vsaw.bst, which are selected under the control of mode selector 214 to output saw-tooth waveform Vsaw. The saw-tooth waveforms may be 2.5 Mhz saw-tooth waveforms, although other waveforms could be used. The saw-tooth waveform is compared with Vc in the PWM generator 216 to generate the PWM modulated signals 217 used by drivers 220 to generate the PWM modulated signals A, B, C and D, which are used to control the transistors 222, 224, 226 and 228 to produce the desired Vout. Appropriate control of the transistors 222, 224, 226 and 228 is used to raise or lower Vout as needed, such that a Vout can be provided between approximately 2.0V and 4.5V.

The REGREF 106, 206 will adjust the headroom voltage to automatically compensate for the I-V curve drift over the lifetime of the laser diode 202 and compensate for changes in temperature to keep the bias current constant. For example, if the voltage drop across the laser diode 202 were to change due to a change in temperature or due to drift over time, the voltage at the output of the laser driver (Vheadroom) would change and could become too low or too high to provide a headroom with optimal performance. For example, if the voltage Vheadroom was reduced due to a change in temperature and a bigger voltage drop across the laser diode 202, the voltage at the output of REGREF 206 and input to error amplifier EA1 213 would be lowered, resulting in a changed control voltage Vc. The changed control voltage Vc, would result in a changed Vout being applied to the laser diode 202.

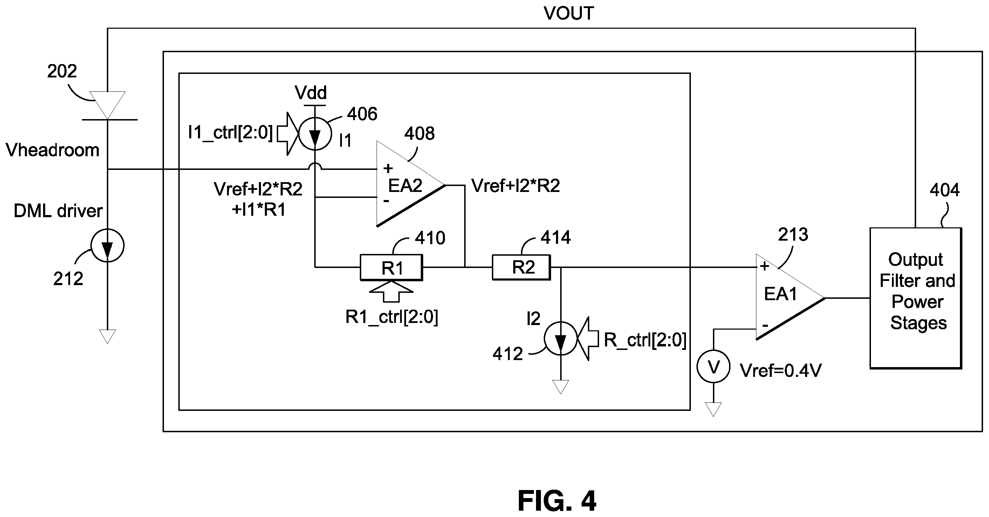

The REGREF 206 is shown in further detail in Fig. 4, along with its connection to the laser diode 202, laser driver 212 and DC-DC converter. The REGREF 206 includes an error amplifier EA2 and a set of programmable resistors R1 410 and R2 414 and programmable current sources I1 406 and I2 412. The headroom voltage Vheadroom at the laser driver 212 is input to the positive input of the error amplifier EA2, and a voltage generated at the output of I1 406 (I1 *R1) is input to the negative input of the error amplifier EA1 213. The voltage at the output of the error amplifier EA2 408 is Vref+I2*R2. When the feedback loop is closed through the DC-DC converter, the voltage Vout will self-adjust in such a way that equation (3) is satisfied: $Vheadroom = Vref + R 2 * I 2 + R 1 * I 1$ (3) I1 is used to generate a voltage (I1*R1) which when added to R2*I2 and Vref at EA1 creates the minimum voltage required by the laser driver for operation Vld_min as shown in equation (4) where I1 and R1 are held constant. This minimum voltage for laser driver operation is typically about 0.7V. $V 1 d _ min = R 2 * I 2 + Vref$ (4) $Imod * Req 1 + I 1 * R 1$ (5)

Importantly, I1 is configured to track the changes in the modulation current of the laser driver 212. This could be accomplished in many ways, such as using a monitoring circuit to monitor changes in the modulation current of the laser driver 212 with the monitoring circuit configured to make corresponding or proportional changes in the programmable current source I1 406.

In closed loop operation, the REGREF 106, 206 will adjust Vc and thus Vout to ensure that equation (3) is valid regardless of the laser diode operation voltage (which may change with temperature/aging) and other IR drops due to board/ferride resistance and the voltage drop of the safety switch (See Fig. 3).

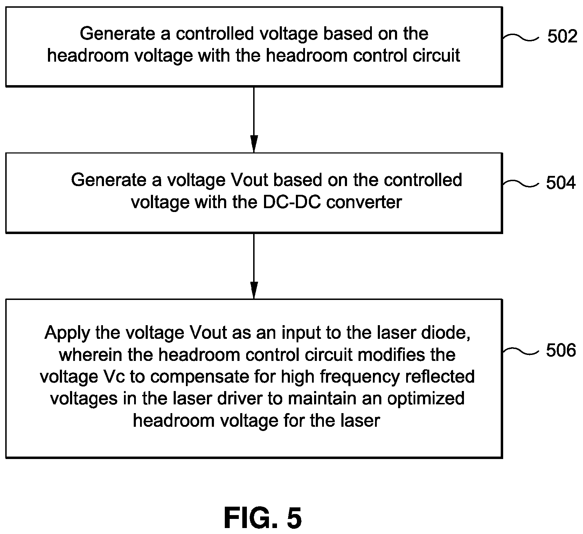

Fig. 5 illustrates a flowchart according to embodiments of the invention. In step 502, the headroom control circuit REGREF generates a controlled voltage based on the headroom voltage Vheadroom. In step 504, the DC-DC converter generates a voltage Vout based on the controlled voltage received from the headroom control circuit.

In step 506, the voltage Vout is applied as an input to the laser diode, wherein the DC-DC converter modifies the voltage Vout to compensate for burn-in characteristics or temperature drift of the laser diode over time to maintain an optimized headroom voltage for the laser driver.

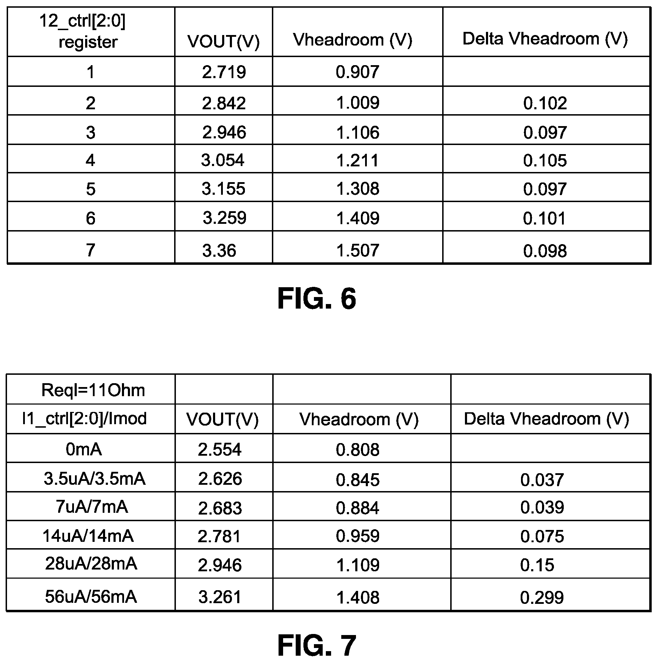

Figure 6 illustrates test results of the headroom control circuit REGREF 206 with changes in a control bit I2_ctrl [2:0] that changes the current injected at programmable current source I2 412 with R1, I1 and R2 held constant. As shown in Fig. 6, each step will change the Vout and Vheadroom by about 100mV. This allows a user of the embodiments of the invention to set a desired headroom Vheadroom by adjusting the programmable current source I2 412. Different currents may be used to produce higher or lower headroom Vheadroom as desired.

Figure 7 illustrates test results of the headroom control circuit REGREF 206 with changes in an injected current applied at programmable current source I1 406. This test set R1 to 11K Ohms and changes the value of I1 with I2 and R2 held constant. For every 3.5 A change in I1, the headroom voltage Vheadroom changes by about 38mV. This allows a user of the embodiments of the invention to set a desired headroom Vheadroom by adjusting the programmable current source I1 406. Different currents may be used to produce higher or lower headroom Vheadroom as desired.

## Claims

1. A circuit for providing an output voltage (Vout) with a headroom voltage to a laser diode (102, 202) driven by a laser driver (112, 212), the laser diode configured to provide signals to an optical communications device, comprising:
a headroom control circuit (106, 206) having an input connected to receive the headroom voltage (Vheadroom) from a connection between the laser diode and the laser driver, the headroom control circuit configured to generate a controlled voltage (Vc) based on the headroom voltage and a modulation current of the laser driver; and
a DC-DC converter (108) connected to receive the controlled voltage (Vc) from the headroom control circuit and to generate the output voltage (Vout) based on the controlled voltage (Vc), and to apply the output voltage (Vout) as an input to the laser diode,
wherein the headroom control circuit and the DC-DC converter are connected in a feedback loop with the laser diode to continuously provide the output voltage (Vout) to the laser diode, and the headroom control circuit controls the controlled voltage (Vc), such that the headroom control circuit compensates for high frequency reflections created by a mismatch impedance of the laser driver with respect to the laser diode in the laser driver to maintain a headroom voltage for the laser driver;
wherein the headroom control circuit includes at least one programmable current source (406) and/or at least one programmable resistor (410).

2. The circuit in accordance with claim 1, wherein the DC-DC converter is configured to generate a control voltage based on the controlled voltage (Vc) from the headroom control circuit, and to generate driver signals to modify the output voltage (Vout) based on a value of the control voltage.

3. The circuit in accordance with claim 2, wherein the DC-DC converter compares the control voltage to a saw-tooth waveform to generate the driver signals to modify the output voltage (Vout) based on a value of the control voltage.

4. The circuit in accordance with claim 1, wherein the DC-DC converter includes a plurality of switches that are controlled by the driver signals to modify the output voltage (Vout) as needed.

5. The circuit in accordance with claim 1, wherein a value that the at least one programmable current source (406) and/or the at least one programmable resistor (410) are set to control the headroom voltage of the laser driver.

6. The circuit in accordance with claim 5, wherein a change of the value that the at least one programmable current source (406) and/or the at least one programmable resistor (410) are set to control the headroom voltage of the laser driver and control the output voltage (Vout) input to the laser diode.

7. A method of controlling a headroom voltage of a laser diode, the laser diode being driven by a laser driver, a headroom control circuit having an input connected to receive the headroom voltage of the laser driver, a DC-DC converter connected to receive a controlled voltage (Vc) from the headroom control circuit and to output an output voltage (Vout) to an input of the laser diode, the method comprising:
generating the controlled voltage (Vc) based on the headroom voltage with the headroom control circuit; and
generating a voltage (Vout) based on the controlled voltage (Vc) with the DC-DC converter, and applying the output voltage (Vout) as an input to the laser diode, wherein the headroom control circuit modifies the output voltage (Vout) to compensate for high frequency reflections created by a mismatch impedance of the laser driver with respect to the laser diode in the laser driver to maintain a headroom voltage for the laser driver,
wherein the method further comprises setting a value of at least one programmable current source (406) and/or at least one programmable resistor (410) in the headroom control circuit to set the headroom voltage to a desired value.

8. The method of claim 7, further comprising generating a control voltage based on the controlled voltage (Vc) from the headroom control circuit, and generating driver signals to modify the output voltage (Vout) based on a value of the control voltage.

9. The method of claim 8, further comprising comparing the control voltage to a saw-tooth waveform to generate the driver signals to modify the output voltage (Vout).

10. The method of claim 9, further comprising controlling a plurality of switches in the DC-DC converter to modify the output voltage (Vout).

## Patentansprüche

1. Schaltung zum Bereitstellen einer Ausgangsspannung (Vout) mit einer Headroom-Spannung an eine Laserdiode (102, 202), die von einem Lasertreiber (112, 212) angesteuert wird, wobei die Laserdiode dazu ausgebildet ist, Signale an eine optische Kommunikationsvorrichtung bereitzustellen, aufweisend:
eine Headroom-Steuerschaltung (106, 206), die einen Eingang aufweist, der angeschlossen ist, um die Headroom-Spannung (Vheadroom) von einer Verbindung zwischen der Laserdiode und dem Lasertreiber zu empfangen, wobei die Headroom-Steuerschaltung dazu ausgebildet ist, eine gesteuerte Spannung (Vc) basierend auf der Headroom-Spannung und einem Modulationsstrom des Lasertreibers zu erzeugen; und
einen DC-DC-Wandler (108), der angeschlossen ist, um die gesteuerte Spannung (Vc) von der Headroom-Steuerschaltung zu empfangen und um die Ausgangsspannung (Vout) basierend auf der gesteuerten Spannung (Vc) zu erzeugen und um die Ausgangsspannung (Vout) als einen Eingang an die Laserdiode anzulegen,
wobei die Headroom-Steuerschaltung und der DC-DC-Wandler in einer Rückkopplungsschleife mit der Laserdiode verbunden sind, um die Ausgangsspannung (Vout) kontinuierlich an die Laserdiode bereitzustellen, und die Headroom-Steuerschaltung die gesteuerte Spannung (Vc) steuert, so dass die Headroom-Steuerschaltung Hochfrequenzreflexionen kompensiert, die durch eine Fehlanpassungsimpedanz des Lasertreibers in Bezug auf die Laserdiode in dem Lasertreiber erzeugt werden, um eine Headroom-Spannung für den Lasertreiber aufrechtzuerhalten;
wobei die Headroom-Steuerschaltung mindestens eine programmierbare Stromquelle (406) und/oder mindestens einen programmierbaren Widerstand (410) enthält.

2. Schaltung nach Anspruch 1, wobei der DC-DC-Wandler dazu ausgebildet ist, eine Steuerspannung basierend auf der gesteuerten Spannung (Vc) von der Headroom-Steuerschaltung zu erzeugen und Treibersignale zu erzeugen, um die Ausgangsspannung (Vout) basierend auf einem Wert der Steuerspannung zu ändern.

3. Schaltung nach Anspruch 2, wobei der DC-DC-Wandler die Steuerspannung mit einer Sägezahnwellenform vergleicht, um die Treibersignale zu erzeugen, um die Ausgangsspannung (Vout) basierend auf einem Wert der Steuerspannung zu ändern.

4. Schaltung nach Anspruch 1, wobei der DC-DC-Wandler eine Mehrzahl von Schaltern enthält, die durch die Treibersignale gesteuert werden, um die Ausgangsspannung (Vout) nach Bedarf zu ändern.

5. Schaltung nach Anspruch 1, wobei ein Wert, auf den die mindestens eine programmierbare Stromquelle (406) und/oder der mindestens eine programmierbare Widerstand (410) eingestellt sind, die Headroom-Spannung des Lasertreibers steuert.

6. Schaltung nach Anspruch 5, wobei eine Änderung des Wertes, auf den die mindestens eine programmierbare Stromquelle (406) und/oder der mindestens eine programmierbare Widerstand (410) eingestellt sind, die Headroom-Spannung des Lasertreibers steuert und die in die Laserdiode eingegebene Ausgangsspannung (Vout) steuert.

7. Verfahren zum Steuern einer Headroom-Spannung einer Laserdiode, wobei die Laserdiode von einem Lasertreiber angesteuert wird, wobei eine Headroom-Steuerschaltung einen Eingang aufweist, der angeschlossen ist, um die Headroom-Spannung des Lasertreibers zu empfangen, wobei ein DC-DC-Wandler angeschlossen ist, um eine gesteuerte Spannung (Vc) von der Headroom-Steuerschaltung zu empfangen und um eine Ausgangsspannung (Vout) an einen Eingang der Laserdiode auszugeben, wobei das Verfahren aufweist:
Erzeugen der gesteuerten Spannung (Vc) basierend auf der Headroom-Spannung mit der Headroom-Steuerschaltung; und
Erzeugen einer Spannung (Vout) basierend auf der gesteuerten Spannung (Vc) mit dem DC-DC-Wandler und Anlegen der Ausgangsspannung (Vout) als einen Eingang an die Laserdiode, wobei die Headroom-Steuerschaltung die Ausgangsspannung (Vout) ändert, um Hochfrequenzreflexionen zu kompensieren, die durch eine Fehlanpassungsimpedanz des Lasertreibers in Bezug auf die Laserdiode in dem Lasertreiber erzeugt werden, um eine Headroom-Spannung für den Lasertreiber aufrechtzuerhalten,
wobei das Verfahren ferner ein Einstellen eines Wertes mindestens einer programmierbaren Stromquelle (406) und/oder mindestens eines programmierbaren Widerstands (410) in der Headroom-Steuerschaltung aufweist, um die Headroom-Spannung auf einen gewünschten Wert einzustellen.

8. Verfahren nach Anspruch 7, ferner aufweisend ein Erzeugen einer Steuerspannung basierend auf der gesteuerten Spannung (Vc) von der Headroom-Steuerschaltung und ein Erzeugen von Treibersignalen, um die Ausgangsspannung (Vout) basierend auf einem Wert der Steuerspannung zu ändern.

9. Verfahren nach Anspruch 8, ferner aufweisend ein Vergleichen der Steuerspannung mit einer Sägezahnwellenform, um die Treibersignale zu erzeugen, um die Ausgangsspannung (Vout) zu ändern.

10. Verfahren nach Anspruch 9, ferner aufweisend ein Steuern einer Mehrzahl von Schaltern in dem DC-DC-Wandler, um die Ausgangsspannung (Vout) zu ändern.

## Revendications

1. Circuit pour fournir une tension de sortie (Vout) avec une tension de headroom à une diode laser (102, 202) attaquée par un circuit d'attaque laser (112, 212), la diode laser étant configurée pour fournir des signaux à un dispositif de communication optique, comprenant :
un circuit de commande de headroom (106, 206) ayant une entrée connectée pour recevoir la tension de headroom (Vheadroom) depuis une connexion entre la diode laser et le circuit d'attaque laser, le circuit de commande de headroom étant configuré pour générer une tension commandée (Vc) sur la base de la tension de headroom et d'un courant de modulation du circuit d'attaque laser ; et
un convertisseur CC-CC (108) connecté pour recevoir la tension commandée (Vc) en provenance du circuit de commande de headroom et pour générer la tension de sortie (Vout) sur la base de la tension commandée (Vc), et pour appliquer la tension de sortie (Vout) en tant qu'entrée à la diode laser,
dans lequel le circuit de commande de headroom et le convertisseur CC-CC sont connectés dans une boucle de rétroaction avec la diode laser pour fournir en continu la tension de sortie (Vout) à la diode laser, et le circuit de commande de headroom commande la tension commandée (Vc), de sorte que le circuit de commande de headroom compense des réflexions haute fréquence créées par une impédance de désadaptation du circuit d'attaque laser par rapport à la diode laser dans le circuit d'attaque laser pour maintenir une tension de headroom pour le circuit d'attaque laser ;
dans lequel le circuit de commande de headroom comporte au moins une source de courant programmable (406) et/ou au moins une résistance programmable (410).

2. Circuit selon la revendication 1, dans lequel le convertisseur CC-CC est configuré pour générer une tension de commande sur la base de la tension commandée (Vc) en provenance du circuit de commande de headroom, et pour générer des signaux d'attaque afin de modifier la tension de sortie (Vout) sur la base d'une valeur de la tension de commande.

3. Circuit selon la revendication 2, dans lequel le convertisseur CC-CC compare la tension de commande à une forme d'onde en dents de scie pour générer les signaux d'attaque afin de modifier la tension de sortie (Vout) sur la base d'une valeur de la tension de commande.

4. Circuit selon la revendication 1, dans lequel le convertisseur CC-CC comporte une pluralité de commutateurs qui sont commandés par les signaux d'attaque afin de modifier la tension de sortie (Vout) selon les besoins.

5. Circuit selon la revendication 1, dans lequel une valeur à laquelle l'au moins une source de courant programmable (406) et/ou l'au moins une résistance programmable (410) sont réglées commande la tension de headroom du circuit d'attaque laser.

6. Circuit selon la revendication 5, dans lequel un changement de la valeur à laquelle l'au moins une source de courant programmable (406) et/ou l'au moins une résistance programmable (410) sont réglées commande la tension de headroom du circuit d'attaque laser et commande la tension de sortie (Vout) en entrée de la diode laser.

7. Procédé de commande d'une tension de headroom d'une diode laser, la diode laser étant attaquée par un circuit d'attaque laser, un circuit de commande de headroom ayant une entrée connectée pour recevoir la tension de headroom du circuit d'attaque laser, un convertisseur CC-CC connecté pour recevoir une tension commandée (Vc) en provenance du circuit de commande de headroom et pour délivrer une tension de sortie (Vout) à une entrée de la diode laser, le procédé comprenant :
la génération de la tension commandée (Vc) sur la base de la tension de headroom avec le circuit de commande de headroom ; et
la génération d'une tension (Vout) sur la base de la tension commandée (Vc) avec le convertisseur CC-CC, et l'application de la tension de sortie (Vout) en tant qu'entrée à la diode laser, dans lequel le circuit de commande de headroom modifie la tension de sortie (Vout) pour compenser des réflexions haute fréquence créées par une impédance de désadaptation du circuit d'attaque laser par rapport à la diode laser dans le circuit d'attaque laser pour maintenir une tension de headroom pour le circuit d'attaque laser,
dans lequel le procédé comprend en outre le réglage d'une valeur d'au moins une source de courant programmable (406) et/ou d'au moins une résistance programmable (410) dans le circuit de commande de headroom pour régler la tension de headroom à une valeur souhaitée.

8. Procédé selon la revendication 7, comprenant en outre la génération d'une tension de commande sur la base de la tension commandée (Vc) en provenance du circuit de commande de headroom, et la génération de signaux d'attaque afin de modifier la tension de sortie (Vout) sur la base d'une valeur de la tension de commande.

9. Procédé selon la revendication 8, comprenant en outre la comparaison de la tension de commande à une forme d'onde en dents de scie pour générer les signaux d'attaque afin de modifier la tension de sortie (Vout).

10. Procédé selon la revendication 9, comprenant en outre la commande d'une pluralité de commutateurs dans le convertisseur CC-CC afin de modifier la tension de sortie (Vout).
